(19) Europäisches Patentamt
European Patent Office
Office européen des brevets

(11) **EP 3 798 661 B1**

(12) **EUROPEAN PATENT SPECIFICATION**

(45) Date of publication and mention of the grant of the patent:
**26.06.2024 Bulletin 2024/26**

(21) Application number: **19199558.8**

(22) Date of filing: **25.09.2019**

(51) International Patent Classification (IPC):
***G01R 33/56*** $^{(2006.01)}$ ***G01R 33/44*** $^{(2006.01)}$

(52) Cooperative Patent Classification (CPC):
**G01R 33/443; G01R 33/5608**

(54) **MRI METHOD TO DETERMINE A SUSCEPTIBILITY DISTRIBUTION OF AN EXAMINATION SUBJECT**

MRT-VERFAHREN ZUM BESTIMMEN EINER SUSZEPTIBILITÄTSVERTEILUNG EINES UNTERSUCHUNGSTEILNEHMERS

PROCÉDÉ IRM POUR DÉTERMINER UNE DISTRIBUTION DE SUSCEPTIBILITÉ D’UN SUJET D’EXAMEN

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.03.2021 Bulletin 2021/13**

(73) Proprietor: **Siemens Healthineers AG**
**91301 Forchheim (DE)**

(72) Inventors:
- **Niederlöhner, Daniel**
  **91054 Erlangen (DE)**
- **Ritter, Dieter**
  **90762 Fürth (DE)**
- **Schäfer, Andreas**
  **90763 Fürth (DE)**
- **Sukkau, Johann**
  **91074 Herzogenaurach (DE)**

(74) Representative: **Siemens Healthineers Patent Attorneys**
**Postfach 22 16 34**
**80506 München (DE)**

(56) References cited:
**WO-A1-2019/157174 US-A1- 2004 032 261**

- **LUNDERVOLD ALEXANDER SELVIKVÅG ET AL: "An overview of deep learning in medical imaging focusing on MRI", ZEITSCHRIFT FUER MEDIZINISCHE PHYSIK, vol. 29, no. 2, 13 December 2018 (2018-12-13), pages 102-127, XP085671903, ISSN: 0939-3889, DOI: 10.1016/J.ZEMEDI.2018.11.002**
- **BASTY NICOLAS ET AL: "Super Resolution of Cardiac Cine MRI Sequences Using Deep Learning", 12 September 2018 (2018-09-12), 12TH EUROPEAN CONFERENCE ON COMPUTER VISION, ECCV 2012; [LECTURE NOTES IN COMPUTER SCIENCE], SPRINGER BERLIN HEIDELBERG, BERLIN, HEIDELBERG, PAGE(S) 23 - 31, XP047526324, ISSN: 0302-9743 ISBN: 978-3-642-36948-3 [retrieved on 2018-09-12] * the whole document ***
- **XIAO-YUN ZHOU ET AL: "Atrous Convolutional Neural Network (ACNN) for Biomedical Semantic Segmentation with Dimensionally Lossless Feature Maps", ARXIV.ORG, CORNELL UNIVERSITY LIBRARY, 201 OLIN LIBRARY CORNELL UNIVERSITY ITHACA, NY 14853, 26 January 2019 (2019-01-26), XP081008526,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 798 661 B1

**Description**

The present invention concerns a computer-implemented method, a computer program and a magnetic resonance apparatus to determine a current susceptibility distribution of an examination subject.

In magnetic resonance (MR) several electromagnetic fields are used to produce the desired signal. A basic magnetic field, usually called $B_0$, is used to align nuclear spins of a subject. In order to generate magnetic resonance signals, excitation of these nuclear spins causes the spins to emit signals at the resonance frequency. The excitation is based on radio frequency (RF) pulses, the field of which is called $B_1$. After the application of an RF pulse, the excited magnetization decays and the decaying signal is detected.

If the $B_0$ field or the $B_1$ field as well as the gradient fields are not homogeneous, a uniform excitation cannot be obtained. Therefore, all fields and in particular the basic magnetic field $B_0$ have to be as homogeneous as possible to obtain good image quality.

To make the basic magnetic field homogeneous, it is known to use different kinds of shim devices in a magnetic resonance apparatus. Passive shim devices, such as inserted metal parts, are used for constant compensation and are useful to compensate inhomogeneities in the apparatus structure. Passive shim devices are not appropriate for compensation of inhomogeneities introduced by the examination subject. In particular, when a part of a human body is positioned in the $B_0$ field of an MR scanner, the $B_0$ field is distorted because of the variations in magnetic susceptibility in the body part. Especially abrupt changes in magnetic susceptibility, e.g. at air/tissue boundaries, cause significant $B_0$ inhomogeneities. To compensate for such variable inhomogeneities, active shim devices are known. Active shim devices have shim coils which are operated with different shim currents and optimize the homogeneity specifically for certain recording region.

To determine the shim currents for a particular examination subject, usually an adjustment volume is first defined in which the optimization should be effective. The adjustment volume can be defined such that the recording region is contained therein. Then a basic magnetic field map, called $B_0$ map, is determined at least for the adjustment volume.

Methods for generating such a $B_0$ map are known in the art. According to one method, the phase shift, which occurs on the basis of different resonance frequencies in various spatial regions, is measured. The deviation of the resonance frequencies from one another is a measure of the basic magnetic field difference between the various spatial regions, so that a map of the $B_0$ field (referred to as $B_0$ map) may be obtained. Since the shim currents were known during the measurement of the $B_0$ map, on the basis of the known shim fields generated by the shim coils, a combination of shim fields can now be obtained in an optimization method such that an optimum possible homogeneity in the adjustment volume is given. For example, the solution of a system of equations can be sought and/or a simulation can be performed.

A further method to determine the shim currents is to determine the magnetic susceptibility distribution of the examination subject and to use this distribution to calculate a $B_0$ map, which may then be used to determine suitable shim currents in the known way.

The article by Rares Salomir et al: "A Fast Calculation Method for Magnetic Field Inhomogeneity due to an Arbitrary Distribution of Bulk Susceptibility", Concepts in Magnetic Resonance Part B, 19B (1), p. 26 - 34, 2003 discloses a method for calculating the distortion of the $B_0$ field caused by a human body or patient from its distribution of magnetic susceptibility. The susceptibility distribution in the phantom used was modeled by segmenting an MR-image of the phantom into its basic constitutes, such as water and air, and assigning the known susceptibility values of these materials to the segmented area. Thus, essentially the image is binarized into voxels depicting air (value=0) and voxels depicting tissue (value=1).

However, this method may not easily be applied to in vivo measurements, for various reasons: First of all, shimming is a pre-examination procedure, which must be executed within a very short time, since it must not prolong overall examination time. Therefore, acquiring high-resolution 3D spin-echo images, or even high-resolution FLASH-images, as proposed by Salomir et al, simply to determine a 3D susceptibility matrix is not an option. Further, the human body is more complex than a phantom, and assigning susceptibility values is not trivial.

The publication WO 2019/157174 A1 discloses a method for producing a quantitative susceptibility map. The publication US 2004/032261 A1 discloses a method of correcting distortions in magnetic resonance data. The publication LUNDERVOLD LEXANDER SELVIKVÄG ET AL: "An overview of deep learning in medical imaging focusing on MRI", ZEITSCHRIFT FUER MEDIZINISCHE PHYSIK, vol. 29, no. 2, pages 102-127, 13 December 2018 discloses a method for reconstructing a higherresolution image or image sequence from a low-resolution image. The publication BASTY NICOLAS ET AL: "Super Resolution of Cardiac Cine MRI Sequences Using Deep Learning", 12 September 2018, 12TH EUROPEAN CONFERENCE ON COMPUTER VISION, ECCV 2012; [LECTURE NOTES IN COMPUTER SCIENCE], PAGE(S) 23 - 31 discloses a super resolution network based on the U-net and long short-term memory layers to exploit the temporal aspect of the dynamic cardiac cine MRI data.

It is therefore an object of the invention to provide a method of determination of an improved current susceptibility distribution of an examination subject within a short measuring time.

These and other objects are met or exceeded by a computer-implemented method to determine a susceptibility distribution (52) of an examination subject, in accordance with any one of claims 1 to 4.

The method is usually to be carried out while the examination subject is within the magnetic resonance apparatus. It is part of the adjustment measurements carried out at the beginning of the examination session, before the imaging measurements for diagnosis. The proposed method can be part of method to determine the shim currents.

The invention has realized that a method of calculating magnetic field inhomogeneity on the basis of a susceptibility distribution, as described in the above-mentioned article by Salomir et al, requires a better susceptibility distribution than can be estimated from MR image dataset that may be acquired within a short time from the recording region, i.e. a region in which the region of interest for later imaging measurements for diagnosis will presumably be placed. Because of the time constrains during a patient examination, the MR image dataset is usually acquired with a relatively low resolution, i.e. with a relatively large pixel size. Especially at sharp boundaries in magnetic susceptibility in the examined object, such as air-tissue interfaces, this may lead to partial volume effects within the voxel, which may lead to an incorrect assignment of magnetic susceptibility and/or to voxel-based numeric errors in the calculated basic magnetic field. Further, again due to the time constrains, the recording region of the MR image used for estimation of the susceptibility distribution is limited, in particular in z-direction, which in many MR scanners corresponds to the headfoot direction of a human subject. In other words, the examination subject is generally larger than the recording region, especially in z-direction, which means that the body regions outside the recording region also have a susceptibility distribution, which will influence the magnetic field inside the recording region and, therefore, inside the region of interest of subsequent diagnostic measurements. This may lead to strong falsifications in the calculated $B_0$ field. These errors may be significant and may be especially strong at the borders of the recording region, but may also project inside the recording region/volume.

A further challenge is posed by the lung and generally the respiratory system in human subjects. If one attempts to segment this relatively airy tissue into voxels covering tissue and voxels covering air, so that the respective susceptibility values for air and tissue can be assigned, this may lead to a calculated susceptibility distribution having a more or less random distribution of voxels having the value 0 or 1. This very discontinuous distribution does not correspond to the actual more homogenous lung structure. This also leads to incorrect values for the calculated $B_0$ field.

The above-identified problems could theoretically be solved by acquiring an MR image with very high resolution and covering a very large recording area in all three directions. Thereby, the region of interest would be fully comprised therein and the border of the recording area, which might cause errors in the estimated susceptibility distribution, is far enough from the field of view of the diagnostic measurements, to which the shim currents should be optimized. However, the acquisition of such an MR image would take very long (at least several minutes) and is therefore not practical.

However, all of the above challenges can be met by using a machine-learning algorithm, in particular one or several artificial neural networks (in the following: NN), in particular, deep neural networks. The one or several NNs are used for generating a susceptibility distribution having a higher resolution and/or covering an output region, which is larger than the recording region of the MR image dataset acquired from the examination subject. In the context of this invention, the term susceptibility refers to magnetic susceptibility, or estimates thereof. A susceptibility distribution is a map of susceptibility values covering the output region. Thus, it is usually a three-dimensional matrix of assigned susceptibility values.

The MR image dataset may have a low resolution of e.g. > 2mm voxel size in at least one or all imaging directions. The recording region is the volume covered by the MR image dataset (e.g. its field of view). The MR image dataset may be a stack of two-dimensional (2D) images, which together cover a certain volume, i.e. the recording region. The MR image dataset may alternatively be a three-dimensional (3D) image dataset. The step of acquiring the MR image dataset may be part of the inventive method. Such MR image dataset may be received by a computational unit via a first interface. The susceptibility distribution may be outputted, e.g. via a second interface. The method may further include a step of calculating magnetic field inhomogeneity from the susceptibility distribution, which may be carried out for example according to the method by Salomir et al. Further, the method may include a step of optimizing shim currents in order to homogenize the basic magnetic field, in preparation for the acquisition of further MR data from the examination subject, for example diagnostic imaging or spectroscopy.

In an embodiment, the MR image dataset is a three dimensional (3D) dataset. Then it has a total number of $N_{ges} = N_x \times N_y \times N_z$ voxels. A 2D image dataset has only $N_{ges} = N_x \times N_y$ voxels. Preferably, the magnetic resonance image dataset covers the examination subject only partially, especially in the z-direction. This saves acquisition time. Preferably, a fast imaging sequence such as FLASH, TrueFisp, TSE, gradient echo and so on is used to acquire the MR image dataset. Preferably a $T_2$*-sensitive sequence like a gradient echo or FLASH is used. Preferably, the MR image dataset is acquired within 20 seconds, and thus has a relatively coarse resolution on of >2mm

An image has a resolution and field of view in every imaging direction. The imaging directions may be for example the frequency encoding direction x, the phase encoding direction y and the slice selection direction z. The resolution is defined as

$$\Delta w = FoV / N,$$

the field of view (FoV) being the distance over which the image is acquired and N being the number of pixels over the field of view. The resolution $\Delta w$ can be calculated in every imaging direction and is usually called $\Delta x$ in the frequency encoding direction, $\Delta y$ in the phase encoding direction and $\Delta z$ in the slice selection direction. Then the fields of view have respective indices $FoV_x$, $FoV_y$ and $FoV_z$. Also the numbers of pixel are indexed as $N_x$, $N_y$ and $N_z$.

In this nomenclature, a higher resolution means that the size of each pixel is decreased. In other words, a higher resolution is designated with a lower value for $\Delta w$.

The computational unit executing the method may be any dataprocessing unit, such as a CPU (Central Processing Unit) or other digital data processing equipment. Usually, the method will be executed by a computational unit, which is part of an MR scanner. However, the MR image dataset may also be transferred to a remote server, which executes the method, and returns either the susceptibility distribution or directly the calculated magnetic field inhomogeneity, which is then used by the MR scanner to optimize the shim currents.

According to the invention, the MR image dataset may be used as input image to a trained function based on at least one neural network, wherein the trained function generate an output image having a higher resolution than the input image and/or covering an output region, which is larger than the recording region of the MR image dataset. Preferably, the borders of the output region are far enough removed from the borders of the recording region that any susceptibility changes outside the borders of the output region will not influence the $B_0$ field inside the recording region, thereby effectively avoiding the above-described errors in susceptibility distribution. This precaution is taken preferably in those recording directions, in which the body actually extends, usually in the direction head-feet. On the other hand, if the recording region of the MR image dataset already covers the whole body in the other directions (front-back and left-right), then no further enlargement of the susceptibility distribution is necessary in these directions.

The trained function is based on at least one neural network, as explained in more detail below. A neural network comprises nodes and edges, wherein each edge is a directed connection from a first node to a second node. In embodiments of the present invention, the nodes of the NN can be arranged in layers, wherein the layers can comprise an intrinsic order introduced by the edges between the nodes. In particular, edges can exist only between neighboring layers of nodes. The layers between the input layer and the output layer are termed "hidden layers". A real number may be assigned as a value to every node of the neural network. The values of the nodes of the input layer are the input values of the NN, whereas the values of the nodes of the output layer are the output values of the neural network. Furthermore, each edge may comprise a weight being a real number. To calculate the output values of the neural network, the input values are propagated though the neural network. In particular, the values of the nodes of the n+1-th layer can be calculated based on the values of nodes of the n-th layer by

$$x_j^{(n+1)} = f\left(\sum_i x_i^{(n)} \cdot w_{i,j}^{(n)}\right).$$

Herein, the function f is a transfer function (another term is "activation function"). Known transfer functions are step functions, sigmoid function (e.g. the logistic function, the generalized logistic function, the hyperbolic tangent, the Arctangent function, the error function, the smoothstep function) or rectifier functions. The transfer function is mainly used for normalization purposes.

In particular, the values are propagated layerwise through the neural network, wherein values of the input layer are given by the input of the neural network, wherein values of the first hidden layer can be calculated based on the values of the input layer of the neural network, wherein values of the second hidden layer can be calculated based in the values of the first hidden layer, etc.

Before or after the MR image dataset is fed into the trained function, it may be segmented into regions depicting air and regions depicting biological tissue. Such segmentation may be done by techniques such as thresholding, clustering methods, histogram-based methods, edge detection, region-growing methods or methods based on partial differential equations. Such methods are known in the art. According to one embodiment, the MR image dataset is thereby effectively binarized, i.e. it is segmented into regions covering air and regions covering tissue, wherein a pre-determined susceptibility value of 0 may be assigned to air and e.g. $-9*10^{-6}$ to tissue (considered equivalent to water). In another embodiment, the segmentation step includes segmenting the MR image dataset into air and different kinds of biological tissues, including for example bone, muscle, fat, liver, body fluid (e.g. cerebrospinal fluid), blood vessels and lung tissue. According to a useful embodiment, the MR image dataset is segmented into regions covering three different types of material, namely air, lung and other biological tissue. This allows assigning predetermined susceptibility values to each segmented region, for example 0 to air, $-9*10^{-6}$ (equivalent to water) to other biological tissue and -3 to $-4*10^{-6}$ to lung tissue. It is especially useful to identify lung tissue and assign a special susceptibility value to it, because otherwise the problems of random pixel distribution of air and tissue describe above may arise. According to an embodiment, the segmentation step may also be performed by a neural network.

Depending on whether or not the MR image dataset is first segmented, the input to the trained function may be the original MR image dataset, or the segmented MR image dataset, which means an image dataset, where the grey-scale values of the pixels have been replaced by respective assigned values, such as the susceptibility values just mentioned. Thus, the segmented MR image dataset may be equivalent to a susceptibility distribution (although possibly having a lower resolution and covering a smaller recording area than the susceptibility distribution that is generated by the inventive method). In embodiments where the segmented MR image dataset is used as input image to the trained function, the output image will generally already be a segmented image, thus ideally it already is the susceptibility distribution of the output region. In embodiments using the MR image dataset as input image to the trained function, the output image may either be a synthetic MR image dataset, or it may already be a segmented MR image or a susceptibility distribution of the output region.

The trained function of the invention, may be provided in the form of a software program, but may also be implemented as hardware. Further, the trained function of the invention may additionally comprise code, which is not based on a neural network, for example conventional image processing algorithms, such as segmentation algorithms. Further, the trained function may include one neural network or several NNs, which will generally be in series, i.e. passing the MR image dataset from one NN to the next. Alternatively, two or more NNs may also be applied on the MR image dataset in parallel.

In some embodiments, the number of artificial neurons or nodes of the input layer of a neural network of the invention equals the number of voxels $N_{ges}$ of the MR image dataset. In other embodiments, the neural network, e.g. a first, second, third or single NN, is trained to additionally consider characteristics of the examination subject. Then the number of the artificial neurons or nodes of the input layer of the artificial neural network exceeds the number of voxels of the magnetic resonance image dataset. The artificial neural network may consider for example the patient table position, the examination region, the posture of the examination subject, the age, sex, height or weight of the examination subject, which may be stored in a storage medium. The use of such context knowledge makes the deep learning to converge faster and the results for reliable.

If the NN (first, second, third or single NN) of the invention is to be used on an MR image dataset having a different resolution, i.e. different number of voxels, than the image datasets on which the NN has been trained, preferably the MR image dataset is resampled, so that its size (total number of voxels) corresponds to the number of input nodes which are configured to receive the image input data. In other words, the MR image may be fitted to a constant grid size. In alternative embodiments, the neural network (first, second, third or single) is trained not on voxel data, but on sizeinvariant MR data, for example the Fourier Transforms of the MR image dataset.

According to an embodiment, the trained function comprises a first neural network receiving as input data the MR image dataset or the segmented MR image dataset, and generating as output data an MR image dataset or a segmented MR image dataset having the same content and a higher resolution than the input data. Advantageously, the resolution is increased at least in the slice direction, preferably in all imaging directions. Preferably, the resolution is increased by a predetermined factor, for example a factor between two and four. The first neural network preferably comprises at least one convolutional layer and/or at least one upsampling layer. In other embodiments, it may also comprise fully-connected layers. The first NN may, for example, have between two and eight hidden layers.

For training the first neural network, preferably pairs of MR images are acquired from the same subject and field of view: One with a low resolution and one with a high resolution. The first NN is to be trained to rescale the 2D or 3D-MR image data with low resolution to 2D or 3D-MR image data having a higher resolution. According to another embodiment, the input to the first NN are the segmented or preferably binarized MR image datasets, which then have to be converted to an output segmented MR image dataset having a higher resolution than the segmented input MR image dataset. Thus, the training data are also segmented MR image datasets, which may e.g. be generated from the MR images in low and high resolution as described above. In an embodiment, the segmented MR image datasets are already susceptibility distributions, for example including assigned susceptibility values of 2-5 different materials (e.g. air and two to four different types of tissue).

In an embodiment, the segmented MR image dataset contains only binary data (the distinction between tissue and air), which is enough in many applications, since MR-contrast based on T1 and T2 is not relevant for calculating $B_0$ inhomogeneities.

In an embodiment, the trained function comprises a second neural network receiving as input data an image dataset covering the recoding region and generating as output data an image dataset covering an output region, which is larger than the recording region.

Thus, instead of enlarging the recording area of the MRmeasurements in one or all imaging directions and, thus, increasing acquisition time, a NN can learn to estimate the missing body parts outside the recording region and may, therefore, fill in the outer regions of the output image dataset and/or the susceptibility distribution, e.g. in all three directions in space, at least in z direction.

This method step makes use of reference body atlases, which refer to a library of 3D-images of the human body, which have a larger recording area in at least one imaging direction, preferably in all imaging directions, than the MR image dataset. They may also have a high resolution, for example the target resolution for the susceptibility distribution.

A reference body atlas may include 3D image data of the whole body. The reference body atlas may be obtained using magnetic resonance imaging, but also any other imaging modality, such as CT or X-Ray. In particular, dual source CT can be used to acquire images of high resolution and distinguishing different tissues. In an embodiment, reference body atlases, such as whole-body MR or CT data, are available for training purposes or for executing the method. There may be several reference body atlases acquired from a set of human subjects of different sexes, ages, sizes, heights and/or weights. A classical algorithm may, for example, be programmed to simply select the reference body atlas obtained from the subject which best matches the examination subject in sex, age, size, height and/or weight. In an embodiment, a mixture of classical algorithms or registration methods and a deep NN is implemented.

In a next step, the selected reference body atlas must be rotated and morphed into the current patient position and its image intensities compared to the MR image dataset. This comparison may yield several landmark areas, which indicate which part of the atlas is depicted in the MR image dataset. The missing voxels at the border of the output image may then be filled in by copying the data from the atlas into the output image. This step may also be done with the aid of a second deep NN.

The term "reference body atlas" may also refer to a susceptibility map, which has been generated from image data acquired with a medical imaging modality, for example by assigning pre-determined susceptibility values to different tissue types identified/segmented in the reference body atlas. Herein, such susceptibility maps are also referred to as reference body atlas.

In one embodiment, the method comprises the steps of

- identifying landmark regions on the MR image dataset or the segmented MR image dataset and generating an image dataset including the landmark regions,
- using the image dataset generated in step a) as input data to the second neural network, wherein the second neural network generates as output data an output image dataset covering an output region which is larger than the recording region of its input data.

The first step may be performed by classical methods. A landmark region is a characteristic region of the body, which can be identified well on an MR image dataset, such as certain bone or tissue structures. The landmark region is then the region covering this characteristic structure, and which is useful in registering the MR image dataset with a reference body atlas, which however in this embodiment is performed by a second NN. Such second NN may be trained by pairs of reference body atlases and the corresponding landmark regions identified therein.

To improve the performance of the second NN, it is preferable to mix classical and deep-learning techniques: For example, the landmark regions on the MR image dataset may first be identified using classical segmentation methods, as defined above. More generally, the topology of the MR image dataset is pre-processed as far as possible. In an embodiment, the data of a camera or a pressure sensitive mattress may also be used in the pre-processing of the topology of the MR image dataset, or in identifying the landmark regions.

The image dataset used as input to the second NN thus includes the landmark regions, preferably only the landmark regions, for example it may thus be an image dataset consisting only of contours delineating the landmark regions. In other embodiments, the image dataset may in addition contain the original gray-scale values of the MR image. In a useful embodiment, only the landmark regions are present, and these are extrapolated by the second NN to regions outside the recording region. In one embodiment, also the output of the second NN is an output image containing only the landmark regions. The data may then be filled in from a reference body atlas, which also contains these landmark regions. In another embodiment, the output image dataset of the second NN includes gray-scale values. In this embodiment, the second NN is trained using pairs of a reference body atlas and the landmark regions extracted therefrom.

Using an artificial neural network has two advantages compared to classical registration: First, the morphing and rotating of the reference body atlas into the current position of the examination subject, as well as into his/her individual body in its current posture, does not have to be explicitly programmed. Further, the NN can be trained with a great number of possible postures of a subject including various positions of the extremities (e.g. the superman-position with extended arm), which is easy to implement. Another advantage is that the second NN may be further trained with additional, difficult cases, for example, examination subjects with missing/amputated extremities.

The output image dataset of the second NN may contain MR image data and/or CT image data from the reference body atlases or susceptibility distribution data. Since the image data usually is segmented and assigned a limited number of susceptibility values, it may be computationally more effective to work with susceptibility distribution data already in the second NN. In this embodiment, the second NN may be trained with reference susceptibility distributions, which have been obtained from reference body atlases. For example, a reference body atlas may be segmented into regions of air and regions of tissue or tissues with different susceptibility. Suitable predetermined susceptibility values may then be assigned to the voxels in each region, as described above, for example 0 for the voxels within a region depicting air, and $-9*10^{-6}$ to voxels in a region depicting tissue, and ideally a value inbetween to voxels in regions identified as lung tissue. According to an embodiment, the output image dataset includes landmark regions, and the method comprises the following further steps:

- providing a reference body atlas having a larger recording region than the MR input dataset,
- determining the position of the landmark regions in the output image dataset in the reference body atlas, and
- using image data from the reference body atlas to fill in image content outside the recoding region in the output image.

In an alternative, the data filled in is not from the reference body atlas, but from the reference susceptibility distribution or susceptibility body atlas.

Advantageously, the best fitting reference susceptibility distribution and the MR image dataset are merged to the current susceptibility distribution by replacing those voxels of the best fitting reference susceptibility distribution where voxels of the MR image dataset exist. Hence the voxels of the MR image dataset are used and amended with voxels of the best fitting reference susceptibility distribution in order to obtain a (current) output susceptibility distribution.

The second neural network may be trained to additionally consider data of one or more of the following sensors: camera data, either a 3D camera or an infrared camera or a CCD sensor, or data of a pressure sensitive mattress on which the examination subject lies. Also, any MR data previously acquired in this examination session (such as localizer images) may be considered.

According to the invention, the method comprises a step of segmenting the MR image dataset or the output image of the trained function into regions depicting air and regions depicting biological tissue and assigning a pre-determined susceptibility value to each segmented region, wherein this step is carried out using a third neural network, the third neural network receiving an MR image dataset as input data and generating a susceptibility distribution as output data, the susceptibility distribution including at least values for air, tissue and optionally lung.

This step of segmentation may be done in the beginning, e.g. before the MR image dataset is fed to the first NN. This has the advantage that the image data to be processed are simplified, since they include only a limited number of values, for example three estimates for susceptibility, e.g. 0 for air, $-9*10^{-6}$ for water and -3 to $-4*10^{-6}$ for lung tissue. In this embodiment, the input and output of the first and second neural networks will also be segmented MR image data or already susceptibility maps. The input and output data of the third neural network preferably have the same size, i.e. the same dimensions and the same number of voxels.

According to a further advantageous embodiment, the third neural network is able to distinguish not only between air, tissue and lung, but may also identify further types of tissues such as muscle, fat, liver and/or bone. Thus, suitable pre-determined susceptibility values for these tissues may also be assigned to the respective voxels in the susceptibility distribution. The third NN may be trained by a set of MR images, preferably MR images acquired with the same imaging parameters as the MR image dataset, such as the same imaging sequence, same TE and TR etc. as input training data. The output training data may be segmented images or susceptibility distributions generated from the input training data using classical segmentation techniques as described above. The results of the classical segmentation techniques may have been controlled by humans.

In an embodiment, the third NN is a deep fully-convolutional neural network, i.e. it does not comprise any fully-connected layers. Rather, each neuron is connected to only a small region of the previous layer. For example, the filter kernels in the convolutional layer or layers of the third NN may have a size of 3x3x3 pixels in case of a 3D input image. The third NN may also comprise pooling layers and/or upsampling layers. In an embodiment, the input layer of the third NN has the same number of nodes as the output layer.

In an embodiment, the trained function comprises a single neural network, which is in particular a combination of the first and the second, and optionally third, neural networks. In particular, the first, second and optionally the third NN may be used in series, so that e.g. the output of the first NN is the input to the second NN, or vice versa. In may be computationally more effective to use the low-resolution MR image dataset or segmented MR image dataset (equivalent to a susceptibility distribution) as input to the second NN, whereby the recording region covered by the (segmented) MR image dataset is extended to regions outside, so that it covers the output region. In a next step, the resolution of this larger image is increased using either conventional upsampling techniques, or the first NN.

Generally, the functionality of one or two of the first NN, the second NN and the third NN may be replaced by conventional methods.

Advantageously, the first, second, third or single neural network has at least four, preferably at least 10 hidden layers, i.e. it is preferably a deep NN. Preferably, the first, second, third or single neural network has at least 12 hidden layers. Preferably, the first, second, third or single neural network is a feed-forward network. Preferably, the number of nodes of the input layer of the trained function equals or exceeds the number of voxels of the MR image dataset. Then the value of each voxel of the magnetic resonance image dataset may be the input value of a node of the input layer.

Advantageously, the number of the artificial neurons of at least one hidden layer is at least twice as much as the number of the artificial neurons of the input layer. Using this relationship the results could be improved.

The reference body atlases may be classified into classes of "low", "medium" and "high" with regard to the characteristics "height" and "weight". Additionally the classes may be sex sensitive and have the characteristic "male" or "female". A reference body atlas may be received by measuring one person. Alternatively, a reference body atlas may be the mean of several persons of that classification.

Preferably, a reference susceptibility distribution is a combination of several 3D susceptibility maps. The 3D susceptibility maps may have been acquired from reference subjects having all the same classification, namely the same categories, e.g. "height=medium", "weight=low", "sex=female".

Generally, the first, second, third or single NN may receive as further input data characteristics of the examination subject or the examination session, in particular, one or several of the group comprising:

- posture of the examination subject,
- sex, age, hight and/or weight of the examination subj ect,
- the type of MR sequence used in acquiring the MR image dataset,
- the body part depicted by the MR image dataset,
- the position of the MR table,
- the size of the recording region,
- camera data of the examination subject, in particular from a 3D camera,
- data of a pressure sensitive mattress under the examination subject.

Thereby, the training may converge more quickly.

Embodiments of the invention are also directed to training methods for training of the neural networks described herein.

Accordingly, there is provided a method of training a first neural network useful in generating as output data an MR image dataset or a segmented MR image dataset having a higher resolution than the input data is provided, the method comprising

- receiving input training data, namely a set of MR image datasets or segmented MR image datasets covering various fields-of-view in various body parts and having a low resolution,
- receiving output training data, namely a set of MR image datasets or segmented MR image datasets acquired during the same examination sessions as the input training data and covering the same fields-of-view, but having a higher resolution by a predetermined factor, training the first neural network by using the input training data and the output training data.

There are several ways the second NN can be used, which may infer different training methods: In a first embodiment, the second NN is trained on pairs of a reference body atlas comprising MR image data, or an excerpt of such reference body atlas, namely a 3D-image covering a region, which corresponds in size to the size of the desired output region, as output training data. The input training data can be generated therefrom, and this would be an image dataset corresponding to a smaller region, i.e. it is generated by cutting away the outer portions of the image data sets used as output training data. Various pairs of training datasets are generated from various body parts. Thereby, effectively the second NN is trained to extrapolate MR image data. In an embodiment, several second NNs are trained, each for a different body region, such that for example one second NN only has to learn the anatomy of the abdomen, the other the anatomy in the head, and another the typical anatomy of the chest, in order to extrapolate such data.

In another embodiment, the input and output training data do not comprise MR image data, but susceptibility distributions. For example, one pair of training data will comprise as output training data one image data set containing susceptibility values, which are generated from a (or part of a) reference body atlas by segmentation and assigning susceptibility values, as described herein with reference to claims 3 and 4, and having a recording region, which is larger at least in one imaging direction than the respective input training data. The input training data is also an image data set comprising susceptibility values, but covering only a region corresponding in size to the recording region. This input training dataset may be generated from the output training datasets by cutting away data at the edges. Thereby, training is simplified, since the second NN does not need to learn exact image intensities of the body, but a simplified mask of susceptibilities.

In a further embodiment, the input and output training data include - either in addition to other image data, or exclusively - landmark regions, which identify certain predetermined anatomical structures. Such training data may be generated from the reference body atlases by, for example, known segmentation techniques, as described above. Again, the output training dataset cover a larger region than the input training datasets, so as to train the second NN to extrapolate the landmark regions. This embodiment has further reduced complexity and thereby is robust and reliable. The output of the second NN in this embodiment comprises essentially extrapolated landmark regions. The actual image data in these landmark regions may be taken from the provided reference body atlas. In an embodiment, the landmark regions have not only been extrapolated, but the landmark regions in the input data have also been rotated and/or distorted or morphed, so that they overlap with the landmark regions from the reference body atlas, so as to allow allocation of the image data from the reference body atlas.

A method of training the third neural network comprises:

- Receiving input training data, namely a set of MR image datasets from various recording regions in a human body,
- Receiving output training data, namely a set of image datasets comprising susceptibility distributions including values for at least air, tissue and lung, and optionally for further types of biological tissues, wherein the output training data has been generated from the input training data by segmentation techniques,
- Training the third neural network by using the input training data and the output training data.

Preferably, the output training data have been generated from the input training data using conventional segmentation techniques, preferably by computationally expensive, but precise segmentation techniques. The third NN may facilitate this process.

In an embodiment, the artificial neural networks of this invention are trained on the basis of machine-learning techniques, in particular deep-learning, for example by back propagation.

In embodiments of the invention, each of the first, second, third or single neural network is provided by the disclosed training methods. In particular, the trained function is provided by one or more of the disclosed training methods.

The invention is also directed to a computer program comprising instructions which, when the program is executed by a computational unit, causes the computational unit to carry out the method of one of claims 1 to 11.

In general, a trained function mimic's cognitive functions that humans associate with other human minds. In particular, by training based on training data, the trained function is able to adapt to new circumstances and to detect and extrapolate patterns. In general, parameters of the trained function can be adapted by means of training. In particular, supervised training, semisupervised training, unsupervised training, reinforcement learning and/or active learning can be used. Furthermore, representation learning (an alternative term is "feature learning") can be used. In particular, the parameters of the trained functions can be adapted iteratively by several steps of training.

In particular, a trained function can comprise a neural network, a support vector machine, a decision tree and/or a Bayesian network, and/or the trained function can be based on k-means clustering, Q-learning, genetic algorithms and/or association rules. In particular, a neural network can be a deep neural network, a convolutional neural network or a convolutional deep neural network. Furthermore, a neural network can be an adversarial network, a deep adversarial network and/or a generative adversarial network. In an embodiment, the single NN comprises both convolutional layers as well as fully-connected layers.

In an embodiment, at least the first and second and optionally the third neural network are combined to a single neural network. Preferably, this neural network receives as input data the MR image dataset or the segmented MR image dataset (i.e. a susceptibility distribution, generated from the MR image dataset), and generates as output data an output image having a higher resolution than the input data and/or covering an output region, which is larger than the recording region of the MR image dataset. Preferably, the output is already a susceptibility distribution.

A method of training said single neural network useful in generating a susceptibility distribution of an examination subject comprises:

- Receiving input training data, namely an MR image dataset or a susceptibility distribution having a first resolution and covering a part of the body of the examination subject,
- receiving output trained data, namely an MR image dataset or a susceptibility distribution having a second resolution, which is higher than the first resolution and/or covering an output region, which is larger than the recording region,
- training the single neural network by using the input training data and the output training data.

Preferably, the output data has both a higher resolution and a larger output region than the input data. The single NN may be a combination of the first and second NNs in series, so that first and second NN can be trained separately by the methods described above.

In another embodiment, the single NN is trained as a whole, wherein the output training data is preferably generated from reference body atlases by cutting out suitable output regions and optionally generating susceptibility distributions therefrom. The input training data is then generated from the output training data by reducing the field of view.

Further, the structures may be randomly distorted, so as to train the single NN to deal with variations of the anatomy between various subjects. The single NN preferably comprises at least six, preferably at least twelve hidden layers.

The invention is also directed to a computer program comprising instructions which, when the program is executed by a computer, cause the computer to carry out the method of one of the claims 1 to 13.

In accordance with another aspect of the invention, a magnetic resonance apparatus is disclosed in accordance with claim 13, said apparatus comprising:

- an MR data acquisition scanner comprising an RF transmitter and an RF receiver and a gradient coil arrangement,
- a memory in which magnetic resonance (MR) image datasets, optionally reference susceptibility distributions and a trained function are stored,

- a computer having access to said memory and being configured to read said MR image datasets, optionally said reference susceptibility distributions, and trained function from said memory, and
- said computer being configured to carry out the method described above.

Each of the embodiments described with regard to the method also can be realized in all other claim categories.

Embodiments of the invention shall now be described with reference to the attached figures. Parts that correspond to one another are labeled with the same reference characters in all figures.

Fig. 1 shows an embodiment of a magnetic resonance apparatus,
Fig. 2 shows a trained artificial neural network,
Fig. 3 shows a first reference susceptibility distribution,
Fig. 4 shows a second reference susceptibility distribution,
Fig. 5 shows a flow diagram illustrating a method of generating a susceptibility distribution according to a first embodiment,
Fig. 6 shows a flow diagram illustrating a method of generating a susceptibility distribution according to a second embodiment,
Fig. 7 shows a flow diagram illustrating a method of generating a susceptibility distribution according to a third embodiment, and
Fig. 8 shows a procedure diagram of getting shim currents using a deep artificial neural network according to an embodiment of the invention.

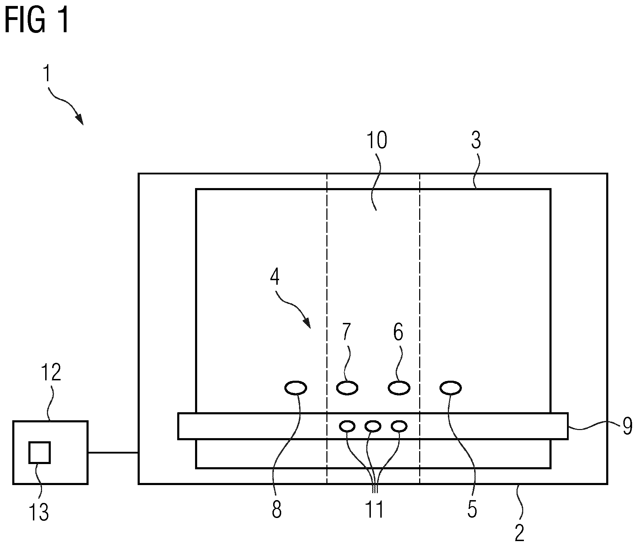

FIG. 1 shows a magnetic resonance apparatus 1. The magnetic resonance apparatus 1 has a scanner 2. A transmit coil arrangement 3 is part of the scanner 2. The transmit coil arrangement 3 is usually designed as a body coil, and may thus consist of a single coil. Additionally, the magnetic resonance apparatus 1 has a receive coil arrangement 4. The receive coil arrangement 4 is designed as a coil array having coils 5, 6, 7 and 8.

The receive coil arrangement 4 usually is laid on a movable patient table 9 and is positioned at least partly within the homogeneous region 10 of the scanner 2. The homogeneous region 10 is marked with dashed lines. The homogeneous region is that part of the scanner where the basic magnetic field $B_0$ is without greater disturbances and an examination subject can be examined. Disturbances introduced by an examination subject into region 10 are compensated by shim coils 11.

A control computer 12 controls the operation of the magnetic resonance apparatus 1.

The control computer 12 may comprise a computational unit for carrying out the methods according to the invention, wherein the computational unit may be any data processing unit such as CPU, GPU, etc. The processing unit may be part of any computer, not only a control computer 12 connected to a magnetic resonance apparatus 1, but also a stand-alone PC, a local or remote server, a cloud computer, as well as the processing unit of a mobile device such as a laptop, tablet computer, mobile phone, etc.

The magnetic resonance apparatus 1 also has a non-transitory data storage medium 13 as part of the control computer 12 or independent thereof, on which computer code for carrying out magnetic resonance measurements is stored.

The coil array 4 is used only to read out the measurement signal which can be an echo signal. The coils 5, 6, 7 and 8 of the coil array 4 read out the measurement signal at the same time. Further components of the magnetic resonance apparatus 1, such as gradient coils are not shown, for clarity.

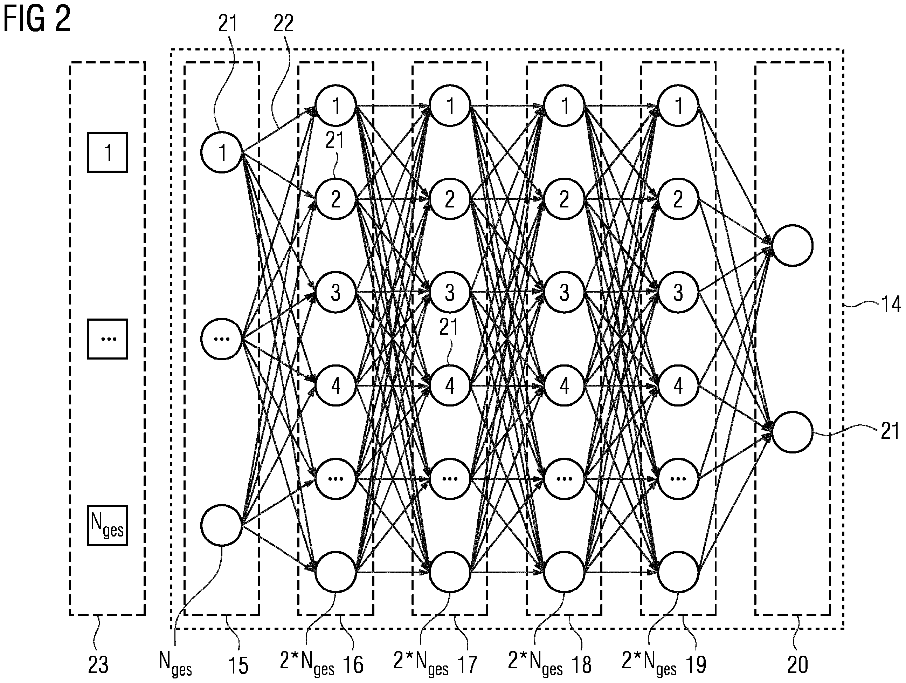

Fig. 2 shows a trained artificial neural network 14 having an input layer 15, at least four hidden layers 16, 17, 18 and 19 and an output layer 20.

Only some of the artificial neurons 21 have reference signs for clarity. The connections (edges) of an output of one artificial neuron 21 to the input of a different artificial neuron 21 is represented by arrows 22.

Input layer 15 has a number $N_{ges}$ of artificial neurons 21 which equals the number of voxels of the MR image datasets used as input to (and for training) the artificial neural network 14. The numbers of the artificial neurons represent a counter counting the neurons of a layer. Each hidden layer 16 to 19 has preferably $2^* N_{ges}$ artificial neurons 21. The size of the output layer depends on the information to be returned. If the output layer contains MR image data or the complete current susceptibility distribution, it has a number $N_{SD} > N_{ges}$ or $N_{SD} = N_{ges}$ artificial neurons 21. $N_{SD}$ is here the number of voxels of the current susceptibility distribution which is a three dimensional image or array of susceptibility values.

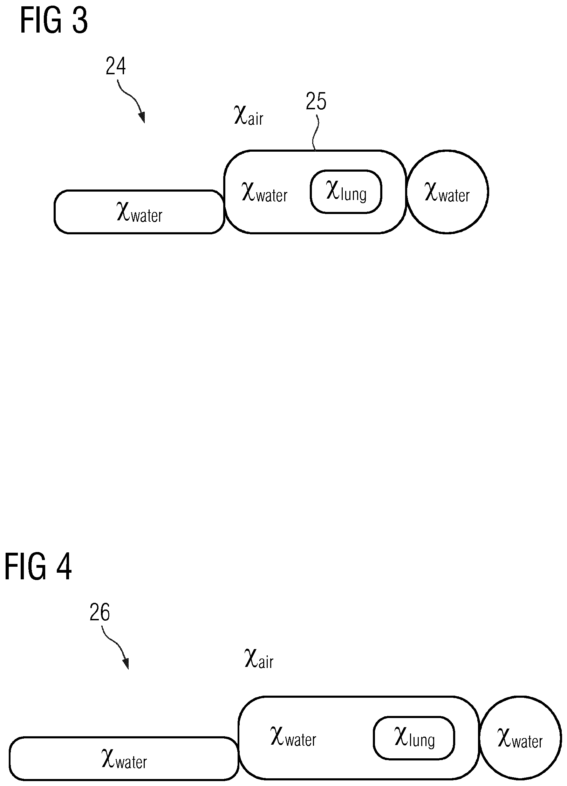

Fig. 3 shows a cross section of a simple reference susceptibility distribution 24 showing a reference subject 25 where only three susceptibility values are distinguished. Air has a susceptibility $\chi_{air} = 0$, the lung has a value of $\chi_{lung} = -3*10^{-6}$ and water has $\chi_{water} = -9*10^{-6}$. Additional tissues and respective susceptibilities can be considered like muscle, fat and bone. Then the reference susceptibility distribution 24 gets more realistic and the calculated shim currents compensate the distortions introduced by the examination subject better.

Reference susceptibility distribution 24 could be classified. There could be three categories having values like: height = "low", weight = "medium", sex = "male".

Fig. 4 shows a second reference susceptibility distribution 26 being classified as height = "high", weight = "medium", sex = "male". The only difference is the height of the reference subject. As one can see, this results in a bigger volume of the lung and the respective susceptibility values.

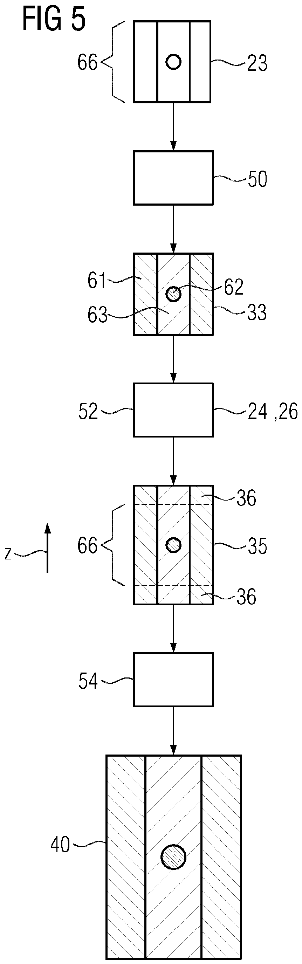

Fig. 5 shows a flow diagram demonstrating an embodiment of the method according to claim 1. A fast MR image dataset 23 has been acquired of a part of the body of the examination subject, for example a part of the leg. The MR image dataset 23 is shown as a single 2D image, but may also be a stack of 2D images or a 3D image, but with low resolution and small field-of-view (recording region 66), such as can be acquired within about 5-30 seconds. In a next step 50, the image is segmented into regions 61 depicting air and regions depicting two or more different types of tissues 62, 63. These different regions are shown by different shadings in the segmented image 33. Optionally, the segmented MR image dataset 33 already contains the predetermined susceptibility values, which are assigned to each different region/tissue type 61, 62, 63 and is thus a susceptibility distribution. This segmentation step 50 is performed using a third NN as described herein.

In a next step 52, a second NN is used to increase the field of view of segmented MR image dataset 33 to image dataset 35, by extrapolating into regions 36 outside the recording region 66. Since the leg extends in z-direction, it is useful especialy to extend the recording region 66 to border regions 36, which extend above and below the recording region 66 in z-direction.

In accordance with the invention, the second NN 52 will have access to reference body atlases 24, 26.

The image dataset 35, having a larger output region than the recording region, is then processed by a further NN 54, which is a first NN and thus generates as output an image dataset 40 having a higher resolution than the MR dataset 23, whereas datasets 23, 33 and 35 all have the same resolution, wherein datasets 23 and 33 have the same size, and 35 has more pixels/voxels in at least one imaging direction. In this embodiment, the image dataset 40 already is the susceptibility distribution of the output region. In other embodiments, the final susceptibility distribution will be computed from the output of the NNs by segmentation and assigning of susceptibility values.

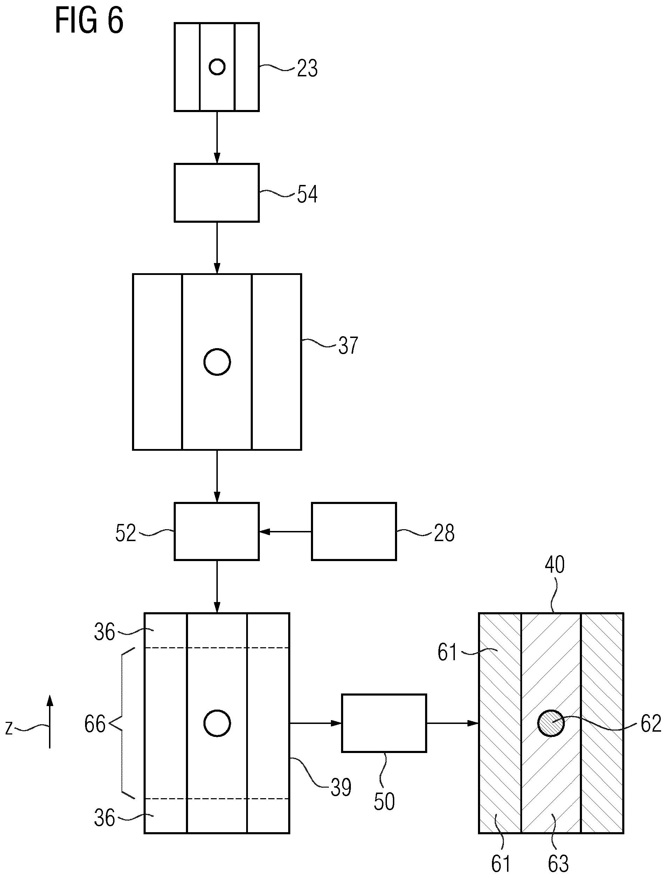

Fig. 6 shows another embodiment of the method of claim 1. In this embodiment, the MR image dataset 23 is first processed by a first NN 54, which increases the resolution, to produce an MR image dataset 37 showing the same content and covering the same recording region, but having higher resolution, i.e. more pixels in at least one imaging direction, preferably in all imaging directions. The MR image dataset 37 is used as input to a second NN 52, which has access to a library 28 of reference body atlases. This second NN generates as output an image dataset 39 having the same resolution as image dataset 37, but covering an output region, which is larger than the recording region 66, since it is extended in z-direction to border regions 36.

In a next step 50, which is performed by a third NN, the image dataset 39 is segmented into regions 61 covering air and regions 62, 63 covering different types of tissue. This dataset 40 is then used to calculate $B_0$ inhomogeneities within the recording region 66.

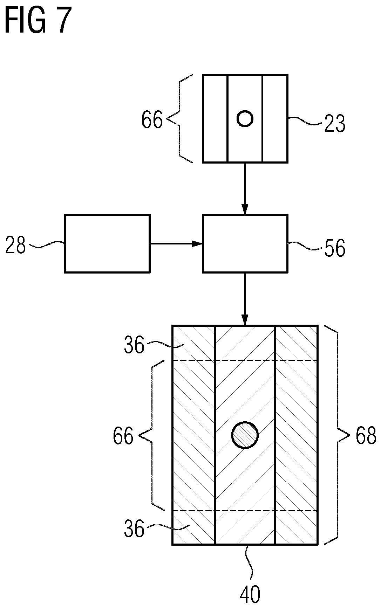

As is evident from figures 5 and 6, the neural networks 50, 52 and 54 operate in series. Accordingly, they may also be combined into a single NN 56, shown in Fig. 7. Therein, an MR image dataset 23 is used as input data to a single NN 56, which gives as output data an MR image dataset or a susceptibility distribution 40 covering an output region 68, which is larger than the recording region 66, since it also extends to border region 36, e.g. the data have been extrapolated. Further, it has a higher resolution than MR image dataset 23. The single NN 56 may access one or several reference body atlases 24, 26 contained in the library 28. This susceptibility distribution 40 may be used for calculating $B_0$ inhomogeneities and hence shim currents, as explained herein. The single NN 56 is preferably a deep NN comprising both convolutional layers and fully-connected layers. Further, it preferably has at least one hidden layer having a number of artificial neurons, which is at least twice as high as the number of artificial neurons of the input layer.

The reference body atlases 24, 26 may be obtained by spiral CT, which allows scanning the whole body in one go. Alternatively, they may be obtained by acquiring several 3D image datasets, which overlap, and merging them to a whole-body reference atlas. Optionally, the reference body atlases may be converted to susceptibility maps by segmenting the different tissue types and assigning pre-determined susceptibility values.

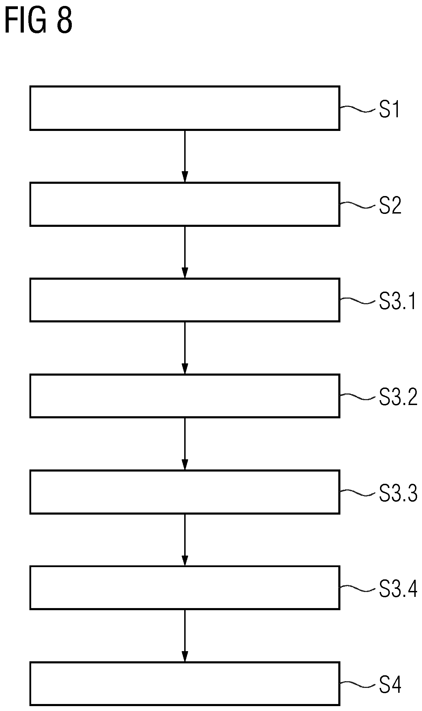

Fig. 8 shows a flow diagram of a further embodiment getting shim currents using a deep artificial neural network including determining a susceptibility distribution of an examination subject using a deep artificial neural network.

In step S1, an examination subject is placed on a patient table and positioned within a magnetic resonance apparatus 1. Then the resonance frequency is measured in step S2. In step S3.1, a magnetic resonance raw dataset is acquired. The magnetic resonance raw dataset is used for determining shim currents and includes at least one susceptibility information. The magnetic resonance raw dataset may include several image datasets covering the same examination volume but acquired with different $T_2$*-weight. The raw dataset is processed to a (3D) MR image dataset 23 using e.g. FFT in step S3.2.

MR image dataset 23 is handed over to the trained artificial neural network 14. Trained artificial network 14 takes the voxels of MR image dataset 23 as input. Also the position of magnetic resonance image dataset 23 within the best fitting reference susceptibility distribution is identified.

In step S3.4 the current susceptibility distribution 40 having a larger output region and/or resolution than magnetic resonance image dataset 23 is calculated. This may be done as described with regard to Fig. 5-7. Finally, in step S4 the shim currents are calculated using the current susceptibility distribution 40. After having completed further adjustments, the examination measurements can start.

The advantage of the methods, systems and apparatus described herein is a higher robustness, size and precision of the susceptibility distributions/maps, which have been pre-processed and/or increased in the field of view by artificial intelligence. In particular, by increasing the resolution and segmentation using deep learning, the generated susceptibility distributions are more exact and correspond more to the real distribution in the body, resulting in a greater robustness and precision of the calculated shim currents. An advantage of the second NN is a susceptibility map, which has a greater spatial extension compared to the measured recording region/volume. This also translates to a more robust and correct $B_0$ distribution and thus greater robustness of the calculated shim currents. Therefore, effectively the required measurement time, in particular the acquisition time of the MR image dataset, is reduced, while achieving the same or an improved $B_0$ homogeneity by shimming.

## Claims

**1.** A computer-implemented method to determine a susceptibility distribution (40) of an examination subject, the method comprising the steps:

a) receiving an MR image dataset (23) acquired during an examination session from a recoding region (66) covering a part of the body of the examination subject and having a first resolution ($\Delta$x),
b) segmenting the MR image dataset into regions depicting air (61) and regions depicting biological tissue (62, 63) and assigning a pre-determined susceptibility value to each segmented region, wherein this step b) is carried out using a trained third neural network (50), the third neural network receiving an MR image dataset (23) as input data and generating a susceptibility distribution (33) as output data, the susceptibility distribution including at least values for air, tissue and optionally lung,
c) applying a trained function based on at least one trained neural network (56) to the susceptibility distribution (33) as input data, wherein the trained function generates as output data an output image (40) having a higher resolution ($\Delta$w) than the MR image dataset or the segmented MR image dataset,
d) providing a final susceptibility distribution (40) which is based on the output image.

**2.** A computer-implemented method to determine a susceptibility distribution (40) of an examination subject, the method comprising the steps:

a) receiving an MR image dataset (23) acquired during an examination session from a recoding region (66) covering a part of the body of the examination subject and having a first resolution ($\Delta$x),
b) applying a trained function based on at least one trained neural network (56) to the MR image dataset (23) as input data, wherein the trained function generates as output data an output image (40) having a higher resolution ($\Delta$w) than the MR image dataset,
c) segmenting the output image of the trained function into regions depicting air (61) and regions depicting biological tissue (62, 63) and assigning a pre-determined susceptibility value to each segmented region, wherein this step c) is carried out using a trained third neural network (50), the third neural network receiving the output image as input data and generating a susceptibility distribution (33) as output data, the susceptibility distribution including at least values for air, tissue and optionally lung,
d) providing a final susceptibility distribution (40) which is based on the susceptibility distribution of step c).

**3.** A computer-implemented method to determine a susceptibility distribution (40) of an examination subject, the method comprising the steps:

a) receiving an MR image dataset (23) acquired during an examination session from a recoding region (66) covering a part of the body of the examination subject and having a first resolution ($\Delta$x),
b) segmenting the MR image dataset into regions depicting air (61) and regions depicting biological tissue (62, 63) and assigning a pre-determined susceptibility value to each segmented region, wherein this step b) is carried out using a trained third neural network (50), the third neural network receiving an MR image dataset (23) as input data and generating a susceptibility distribution (33) as output data, the susceptibility distribution including at least values for air, tissue and optionally lung,
c) applying a trained function based on at least one trained neural network (56) to the susceptibility distribution (33) as input data, wherein the trained function generates as output data an output image (40) having a higher resolution ($\Delta$w) than the MR image dataset or the segmented MR image dataset and/or covering an output region (68) which is larger than the recording region (66) of the MR image dataset (23),
d) providing a final susceptibility distribution (40) which is based on the output image,
wherein the trained function comprises a second neural network (52) receiving as input data an image dataset (33, 37) covering the recoding region (66) and generating as output data an image dataset (35, 39) covering an output region (68), which is larger than the recording region of its input data,
wherein the method comprises the steps of

- identifying landmark regions on the MR image dataset (23) or the segmented MR image dataset (33) and generating an image dataset including the landmark regions,
- using the image dataset generated in step a) as input data to the second neural network (52), wherein the second neural network generates as output data an output image dataset covering an output region which is larger than the recording region of its input data,

wherein the second neural network (52) has been trained on pairs of reference body atlases (24, 26) as output training data and image datasets including landmark regions identified on the corresponding reference body atlases as input training data,
wherein the output image dataset includes landmark regions, and wherein the method comprises the following further steps:

- providing a reference body atlas (24, 26) having a larger recording region (68) than the MR input data (23),
- determining the position of the landmark regions in the output image dataset in the reference body atlas, and

using image data from the reference body atlas (24, 26) to fill in image content (36) outside the recoding region (66) in the output image.

**4.** A computer-implemented method to determine a susceptibility distribution (40) of an examination subject, the method comprising the steps:

a) receiving an MR image dataset (23) acquired during an examination session from a recoding region (66) covering a part of the body of the examination subject and having a first resolution ($\Delta$x),
b) applying a trained function based on at least one trained neural network (56) to the MR image dataset (23) as input data, wherein the trained function generates as output data an output image (40) having a higher resolution ($\Delta$w) than the MR image dataset and/or covering an output region (68) which is larger than the recording region (66) of the MR image dataset (23),
c) segmenting the output image of the trained function into regions depicting air (61) and regions depicting biological tissue (62, 63) and assigning a pre-determined susceptibility value to each segmented region, wherein this step c) is carried out using a trained third neural network (50), the third neural network receiving the output image as input data and generating a susceptibility distribution (33) as output data, the susceptibility distribution including at least values for air, tissue and optionally lung,
d) providing a final susceptibility distribution (40) which is based on the susceptibility distribution of step c),
wherein the trained function comprises a second neural network (52) receiving as input data an image dataset (33, 37) covering the recoding region (66) and generating as output data an image dataset (35, 39) covering an output region (68), which is larger than the recording region of its input data,
wherein the method comprises the steps of

- identifying landmark regions on the MR image dataset (23) or the segmented MR image dataset (33) and generating an image dataset including the landmark regions,
- using the image dataset generated in step a) as input data to the second neural network (52), wherein the second neural network generates as output data an output image dataset covering an output region which is larger than the recording region of its input data,

wherein the second neural network (52) has been trained on pairs of reference body atlases (24, 26) as output training data and image datasets including landmark regions identified on the corresponding reference body atlases as input training data,
wherein the output image dataset includes landmark regions, and wherein the method comprises the following further steps:

- providing a reference body atlas (24, 26) having a larger recording region (68) than the MR input data (23),
- determining the position of the landmark regions in the output image dataset in the reference body atlas, and

using image data from the reference body atlas (24, 26) to fill in image content (36) outside the recoding region (66) in the output image.

**5.** The method of one of the preceding claims, wherein the third neural network has at least four hidden layers.

6. The method of one of the claims 3 to 5, wherein the second neural network has at least four hidden layers and/or the second neural network receives as further input data characteristics of the examination subject or the examination session, in particular one or several of the group comprising:

• posture of the examination subject,
• sex, age, height and/or weight of the examination subj ect,
• the type of MR sequence used in acquiring the MR image dataset (23),
• the body part depicted by the MR image dataset,
• the position of the MR table (9),
• the size of the recording region (66),
• camera data of the examination subject, in particular from a 3D camera,
• data of a pressure sensitive mattress under the examination subject.

7. The method of one of the preceding claims, wherein the trained function comprises a trained first neural network (54) receiving as input data the MR image dataset (23) or the susceptibility distribution (33), and generating as output data an MR image dataset (37) or a further susceptibility distribution (40) having the same content and a higher resolution than the input data.

8. The method of claim 7, wherein the first neural network has at least four hidden layers and/or the first neural network receives as further input data characteristics of the examination subject or the examination session, in particular one or several of the group comprising:

• posture of the examination subject,
• sex, age, height and/or weight of the examination subj ect,
• the type of MR sequence used in acquiring the MR image dataset (23),
• the body part depicted by the MR image dataset,
• the position of the MR table (9),
• the size of the recording region (66),
• camera data of the examination subject, in particular from a 3D camera,
• data of a pressure sensitive mattress under the examination subject.

9. The method of one of the claims 3 to 6 and one of the claims 7 to 8, wherein the trained function comprises a trained single neural network (56), which is in particular a combination of the first and second and optionally third neural networks.

10. The method of claim 9, wherein the single neural network has at least four hidden layers and/or the single neural network receives as further input data characteristics of the examination subject or the examination session, in particular one or several of the group comprising:

• posture of the examination subject,
• sex, age, height and/or weight of the examination subj ect,
• the type of MR sequence used in acquiring the MR image dataset (23),
• the body part depicted by the MR image dataset,
• the position of the MR table (9),
• the size of the recording region (66),
• camera data of the examination subject, in particular from a 3D camera,
• data of a pressure sensitive mattress under the examination subject.

11. The method of one of the claims 5, 6, 8 or 10, wherein the number ($2^*N_{ges}$) of the artificial neurons (21) of at least one hidden layer (16, 17, 18, 19) is at least twice as high as the number ($N_{ges}$) of the artificial neurons (21) of an input layer (15).

12. A computer program comprising instructions which, when the program is executed by a computer (12), cause the computer to carry out the method of one of the claims 1 to 11.

13. A magnetic resonance apparatus (1) comprising:

- an MR data acquisition scanner (2) comprising a radiofrequency transmitter (3) and an RF receiver (4) and a gradient coil arrangement (5, 6, 7, 8),
- a memory in which MR image datasets (23), optionally reference susceptibility distributions, and a trained function (14) are stored,
- a computer (12) having access to said memory (13) and being configured to read said MR image datasets (23), optionally said reference susceptibility distributions (24, 26), and said trained function (14) from said memory (13), and
- said computer (12) being configured to carry out the method of one of claims 1 to 11.

## Patentansprüche

1. Computerimplementiertes Verfahren zur Bestimmung einer Suszeptibilitätsverteilung (40) eines Untersuchungsobjekts, wobei das Verfahren die folgenden Schritte umfasst:

a) Empfangen eines MR-Bilddatensatzes (23), der während einer Untersuchungssitzung aus einer Aufzeichnungsregion (66) erfasst wird, die einen Teil des Körpers des Untersuchungsobjekts abdeckt und eine erste Auflösung (Δx) aufweist,

b) Segmentieren des MR-Bilddatensatzes in Regionen, die Luft (61) darstellen, und Regionen, die biologisches Gewebe (62, 63) darstellen, und Zuordnen eines vorgegebenen Suszeptibilitätswerts zu jeder segmentierten Region, wobei dieser Schritt b) unter Verwendung eines trainierten dritten neuronalen Netzwerks (50) ausgeführt wird, wobei das dritte neuronale Netzwerk einen MR-Bilddatensatz (23) als Eingabedaten empfängt und eine Suszeptibilitätsverteilung (33) als Ausgabedaten erzeugt, wobei die Suszeptibilitätsverteilung zumindest Werte für Luft, Gewebe und optional Lunge umfasst,

c) Anwenden einer trainierten Funktion basierend auf mindestens einem trainierten neuronalen Netzwerk (56) auf die Suszeptibilitätsverteilung (33) als Eingabedaten, wobei die trainierte Funktion als Ausgabedaten ein Ausgabebild (40) erzeugt, das eine höhere Auflösung (Δw) als der MR-Bilddatensatz oder der segmentierte MR-Bilddatensatz aufweist,

d) Bereitstellen einer endgültigen Suszeptibilitätsverteilung (40), die auf dem Ausgabebild basiert.

**2.** Computerimplementiertes Verfahren zur Bestimmung einer Suszeptibilitätsverteilung (40) eines Untersuchungsobjekts, wobei das Verfahren die folgenden Schritte umfasst:

a) Empfangen eines MR-Bilddatensatzes (23), der während einer Untersuchungssitzung aus einer Aufzeichnungsregion (66) erfasst wird, die einen Teil des Körpers des Untersuchungsobjekts abdeckt und eine erste Auflösung (Δx) aufweist,

b) Anwenden einer trainierten Funktion basierend auf mindestens einem trainierten neuronalen Netzwerk (56) auf den MR-Bilddatensatz (23) als Eingabedaten, wobei die trainierte Funktion als Ausgabedaten ein Ausgabebild (40) erzeugt, das eine höhere Auflösung (Δw) als der MR-Bilddatensatz aufweist,

c) Segmentieren des Ausgabebildes der trainierten Funktion in Regionen, die Luft (61) darstellen, und Regionen, die biologisches Gewebe (62, 63) darstellen, und Zuordnen eines vorgegebenen Suszeptibilitätswerts zu jeder segmentierten Region, wobei dieser Schritt c) unter Verwendung eines trainierten dritten neuronalen Netzwerks (50) ausgeführt wird, wobei das dritte neuronale Netzwerk das Ausgabebild als Eingabedaten empfängt und eine Suszeptibilitätsverteilung (33) als Ausgabedaten erzeugt, wobei die Suszeptibilitätsverteilung zumindest Werte für Luft, Gewebe und optional Lunge umfasst,

d) Bereitstellen einer endgültigen Suszeptibilitätsverteilung (40), die auf der Suszeptibilitätsverteilung von Schritt c) basiert.

**3.** Computerimplementiertes Verfahren zur Bestimmung einer Suszeptibilitätsverteilung (40) eines Untersuchungsobjekts, wobei das Verfahren die folgenden Schritte umfasst:

a) Empfangen eines MR-Bilddatensatzes (23), der während einer Untersuchungssitzung aus einer Aufzeichnungsregion (66) erfasst wird, die einen Teil des Körpers des Untersuchungsobjekts abdeckt und eine erste Auflösung (Δx) aufweist,

b) Segmentieren des MR-Bilddatensatzes in Regionen, die Luft (61) darstellen, und Regionen, die biologisches Gewebe (62, 63) darstellen, und Zuordnen eines vorgegebenen Suszeptibilitätswerts zu jeder segmentierten Region, wobei dieser Schritt b) unter Verwendung eines trainierten dritten neuronalen Netzwerks (50) ausgeführt wird, wobei das dritte neuronale Netzwerk einen MR-Bilddatensatz (23) als Eingabedaten empfängt und eine Suszeptibilitätsverteilung (33) als Ausgabedaten erzeugt, wobei die Suszeptibilitätsverteilung zumindest Werte für Luft, Gewebe und optional Lunge umfasst,

c) Anwenden einer trainierten Funktion basierend auf mindestens einem trainierten neuronalen Netzwerk (56) auf die Suszeptibilitätsverteilung (33) als Eingabedaten, wobei die trainierte Funktion als Ausgabedaten ein Ausgabebild (40) erzeugt, das eine höhere Auflösung (Δw) als der MR-Bilddatensatz oder der segmentierten MR-Bilddatensatz aufweist und/oder eine Ausgaberegion (68) abdeckt, die größer als die Aufzeichnungsregion (66) des MR-Bilddatensatzes (23) ist,

d) Bereitstellen einer endgültigen Suszeptibilitätsverteilung (40), die auf dem Ausgabebild basiert,

wobei die trainierte Funktion ein zweites neuronales Netzwerk (52) umfasst, das als Eingabedaten einen Bilddatensatz (33, 37) empfängt, der die Aufzeichnungsregion (66) abdeckt, und als Ausgabedaten einen Bilddatensatz (35, 39) erzeugt, der eine Ausgaberegion (68) abdeckt, die größer als die Aufzeichnungsregion seiner Eingabedaten ist,

wobei das Verfahren die folgenden Schritte umfasst:

- Identifizieren von Landmarkenregionen auf dem MR-Bilddatensatz (23) oder dem segmentierten MR-Bilddatensatzes (33) und Erzeugen eines Bilddatensatzes, der die Landmarkenregionen umfasst,
- Verwenden des in Schritt a) erzeugten Bilddatensatzes als Eingabedaten in das zweite neuronale Netzwerk (52), wobei das zweite neuronale Netzwerk als Ausgabedaten einen Ausgabebilddatensatz erzeugt, der eine Ausgaberegion abdeckt,

die größer als die Aufzeichnungsregion seiner Eingabedaten ist, wobei das zweite neuronale Netzwerk (52) auf Paare von Referenzkörperatlanten (24, 26) als Ausgabetrainingsdaten und Bilddatensätzen, die auf den entsprechenden Referenzkörperatlanten identifizierte Landmarkenregionen umfassen, als Eingabetrainingsdaten trainiert wurde,
wobei der Ausgabebilddatensatz Landmarkenregionen umfasst und wobei das Verfahren die folgenden weiteren Schritte umfasst:

- Bereitstellen eines Referenzkörperatlas (24, 26), der eine größere Aufzeichnungsregion (68) als die MR-Eingabedaten (23) aufweist,
- Bestimmen der Position der Landmarkenregionen im Ausgabebilddatensatz im Referenzkörperatlas und Verwenden von Bilddaten aus dem Referenzkörperatlas (24, 26), um Bildinhalt (36) außerhalb der Aufzeichnungsregion (66) im Ausgabebild aufzufüllen.

**4.** Computerimplementiertes Verfahren zur Bestimmung einer Suszeptibilitätsverteilung (40) eines Untersuchungsobjekts, wobei das Verfahren die folgenden Schritte umfasst:

a) Empfangen eines MR-Bilddatensatzes (23), der während einer Untersuchungssitzung aus einer Aufzeichnungsregion (66) erfasst wird, die einen Teil des Körpers des Untersuchungsobjekts abdeckt und eine erste Auflösung ($\Delta x$) aufweist,
b) Anwenden einer trainierten Funktion basierend auf mindestens einem trainierten neuronalen Netzwerk (56) auf den MR-Bilddatensatz (23) als Eingabedaten, wobei die trainierte Funktion als Ausgabedaten ein Ausgabebild (40) erzeugt, das eine höhere Auflösung ($\Delta w$) als der MR-Bilddatensatz aufweist und/oder eine Ausgaberegion (68) abdeckt, die größer als die Aufzeichnungsregion (66) des MR-Bilddatensatzes (23) ist,
c) Segmentieren des Ausgabebildes der trainierten Funktion in Regionen, die Luft (61) darstellen, und Regionen, die biologisches Gewebe (62, 63) darstellen, und Zuordnen eines vorgegebenen Suszeptibilitätswerts zu jeder segmentierten Region, wobei dieser Schritt c) unter Verwendung eines trainierten dritten neuronalen Netzwerks (50) ausgeführt wird, wobei das dritte neuronale Netzwerk das Ausgabebild als Eingabedaten empfängt und eine Suszeptibilitätsverteilung (33) als Ausgabedaten erzeugt, wobei die Suszeptibilitätsverteilung zumindest Werte für Luft, Gewebe und optional Lunge umfasst,
d) Bereitstellen einer endgültigen Suszeptibilitätsverteilung (40), die auf der Suszeptibilitätsverteilung von Schritt c) basiert, wobei die trainierte Funktion ein zweites neuronales Netzwerk (52) umfasst, das als Eingabedaten einen Bilddatensatz (33, 37) empfängt, der die Aufzeichnungsregion (66) abdeckt, und als Ausgabedaten einen Bilddatensatz (35, 39) erzeugt, der eine Ausgaberegion (68) abdeckt, die größer als die Aufzeichnungsregion seiner Eingabedaten ist,
wobei das Verfahren die folgenden Schritte umfasst:

- Identifizieren von Landmarkenregionen auf dem MR-Bilddatensatzes (23) oder dem segmentierten MR-Bilddatensatz (33) und Erzeugen eines Bilddatensatzes, der die Landmarkenregionen umfasst,
- Verwenden des in Schritt a) erzeugten Bilddatensatzes als Eingabedaten in das zweite neuronale Netzwerk (52), wobei das zweite neuronale Netzwerk als Ausgabedaten einen Ausgabebilddatensatz erzeugt, der eine Ausgaberegion abdeckt,

die größer als die Aufzeichnungsregion seiner Eingabedaten ist, wobei das zweite neuronale Netzwerk (52) auf Paare von Referenzkörperatlanten (24, 26) als Ausgabetrainingsdaten und Bilddatensätzen, die auf den entsprechenden Referenzkörperatlanten identifizierte Landmarkenregionen umfassen, als Eingabetrainingsdaten trainiert wurde,
wobei der Ausgabebilddatensatz Landmarkenregionen umfasst und wobei das Verfahren die folgenden weiteren Schritte umfasst:

- Bereitstellen eines Referenzkörperatlas (24, 26), der eine größere Aufzeichnungsregion (68) als die MR-Eingabedaten (23) aufweist,
- Bestimmen der Position der Landmarkenregionen im Ausgabebilddatensatz im Referenzkörperatlas und Verwenden von Bilddaten aus dem Referenzkörperatlas (24, 26), um Bildinhalt (36) außerhalb der Aufzeichnungsregion (66) im Ausgabebild aufzufüllen.

**5.** Verfahren nach einem der vorhergehenden Ansprüche, wobei das dritte neuronale Netzwerk mindestens vier verborgene Schichten aufweist.

**6.** Verfahren nach einem der Ansprüche 3 bis 5, wobei das zweite neuronale Netzwerk mindestens vier verborgene Schichten aufweist und/oder das zweite neuronale Netzwerk als weitere Eingabedaten Eigenschaften des Untersuchungsobjekts oder der Untersuchungssitzung empfängt, insbesondere eine oder mehrere der Gruppe, die umfasst:

- Haltung des Untersuchungsobjekts,
- Geschlecht, Alter, Größe und/oder Gewicht des Untersuchungsobjekts,
- Typ der MR-Sequenz, der bei der Erfassung des MR-Bilddatensatz (23) verwendet wurde,
- Körperteil, der durch den MR-Bilddatensatz dargestellt wird,
- Position des MR-Tischs (9),
- Größe der Aufzeichnungsregion (66),
- Kameradaten des Untersuchungsobjekts, insbesondere von einer 3D-Kamera,
- Daten einer druckempfindlichen Matratze unter dem Untersuchungsobjekt.

**7.** Verfahren nach einem der vorhergehenden Ansprüche, wobei die trainierte Funktion ein trainiertes erstes neuronales Netzwerk (54) umfasst, das als Eingabedaten den MR-Bilddatensatz (23) oder die Suszeptibilitätsverteilung (33) empfängt und als Ausgabedaten
einen MR-Bilddatensatz (37) oder eine weitere Suszeptibilitätsverteilung (40) mit dem gleichen Inhalt und einer höheren Auflösung als die Eingabedaten erzeugt.

**8.** Verfahren nach Anspruch 7, wobei das erste neuronale Netzwerk mindestens vier verborgene Schichten aufweist und/oder das erste neuronale Netzwerk als weitere Eingabedaten Eigenschaften des Untersuchungsobjekts oder der Untersuchungssitzung empfängt, insbesondere eine oder mehrere der Gruppe, die umfasst:

- Haltung des Untersuchungsobjekts,
- Geschlecht, Alter, Größe und/oder Gewicht des Untersuchungsobjekts,
- Typ der MR-Sequenz, der bei der Erfassung des MR-Bilddatensatz (23) verwendet wurde,
- Körperteil, der durch den MR-Bilddatensatz dargestellt wird,
- Position des MR-Tischs (9),
- Größe der Aufzeichnungsregion (66),
- Kameradaten des Untersuchungsobjekts, insbesondere von einer 3D-Kamera,
- Daten einer druckempfindlichen Matratze unter dem Untersuchungsobjekt.

**9.** Verfahren nach einem der Ansprüche 3 bis 6 und einem der Ansprüche 7 bis 8, wobei die trainierte Funktion ein einziges trainiertes neuronales Netzwerk (56) umfasst, das insbesondere eine Kombination aus dem ersten und dem zweiten und optional dem dritten neuronalen Netzwerk ist.

**10.** Verfahren nach Anspruch 9, wobei das einzige neuronale Netzwerk mindestens vier verborgene Schichten aufweist und/oder das einzige neuronale Netzwerk als weitere Eingabedaten Eigenschaften des Untersuchungsobjekts oder der Untersuchungssitzung empfängt, insbesondere eine oder mehrere der Gruppe, die umfasst:

- Haltung des Untersuchungsobjekts,
- Geschlecht, Alter, Größe und/oder Gewicht des Untersuchungsobjekts,
- Typ der MR-Sequenz, der bei der Erfassung des MR-Bilddatensatz (23) verwendet wurde,
- Körperteil, der durch den MR-Bilddatensatz dargestellt wird,
- Position des MR-Tischs (9),
- Größe der Aufzeichnungsregion (66),
- Kameradaten des Untersuchungsobjekts, insbesondere von einer 3D-Kamera,
- Daten einer druckempfindlichen Matratze unter dem Untersuchungsobjekt.

**11.** Verfahren nach einem der Ansprüche 5, 6, 8 oder 10, wobei die Anzahl ($2*N_{ges}$) der künstlichen Neuronen (21) mindestens einer verborgenen Schicht (16, 17, 18, 19) mindestens zweimal so hoch ist wie die Anzahl ($N_{ges}$) der künstlichen Neuronen (21) einer Eingabeschicht (15).

**12.** Computerprogramm, umfassend Anweisungen, die bei Ausführung des Programms durch einen Computer (12) den Computer zum Durchführen des Verfahrens nach einem der Ansprüche 1 bis 11 veranlassen.

**13.** Magnetresonanzvorrichtung (1), umfassend:

- einen MR-Datenerfassungsscanner (2), der einen Hochfrequenzsender (3) und einen HF-Empfänger (4) und eine Gradientenspulenanordnung (5, 6, 7, 8) umfasst,
- einen Speicher, in dem MR-Bilddatensätze (23), optional Referenzsuszeptibilitätsverteilungen und eine trainierte Funktion (14) gespeichert sind,

- einen Computer (12), der Zugriff auf den Speicher (13) hat und zum Auslesen der MR-Bilddatensätze (23), optional der Referenzsuszeptibilitätsverteilungen (24, 26) und der trainierten Funktion (14) aus dem Speicher (13) konfiguriert ist, und
- wobei der Computer (12) zum Durchführen des Verfahrens nach einem der Ansprüche 1 bis 11 konfiguriert ist.

**Revendications**

**1.** Procédé mis en oeuvre par ordinateur pour déterminer la répartition (40) de susceptibilité d'un sujet en examen, le procédé comprenant les stades :

a) réception d'un ensemble (23) de données d'image RM acquis pendant une session d'examen d'une région (66) d'enregistrement recouvrant une partie du corps du sujet en examen et ayant une première résolution ($\Delta x$),
b) segmentation de l'ensemble de données d'image RM en des régions représentant de l'air (61) et des régions représentant du tissu (62, 63) biologique et affectation d'une valeur de susceptibilité déterminée à l'avance à chaque région segmentée, dans lequel on effectue ce stade b) en utilisant un troisième réseau (50) neuronal d'apprentissage, le troisième réseau neuronal recevant un ensemble (23) de données d'image RM comme donnée d'entrée et créant une répartition (33) de susceptibilité comme donnée de sortie, la répartition de susceptibilité comprenant au moins des valeurs pour de l'air, du tissu et éventuellement du poumon,
c) application d'une fonction d'apprentissage sur la base d'au moins un réseau (56) neuronal d'apprentissage à la répartition (33) de susceptibilité comme donnée d'entrée, dans lequel la fonction d'apprentissage crée comme donnée de sortie une image (40) de sortie ayant une résolution ($\Delta w$) plus grande que celle de l'ensemble de données d'image RM ou de l'ensemble de données d'image RM segmenté,
d) obtention d'une répartition (40) finale de susceptibilité, qui repose sur l'image de sortie.

**2.** Procédé mis en oeuvre par ordinateur pour déterminer la répartition (40) de susceptibilité d'un sujet en examen, le procédé comprenant les stades :

a) réception d'un ensemble (23) de données d'image RM acquis pendant une session d'examen d'une région (66) d'enregistrement recouvrant une partie du corps du sujet en examen et ayant une première résolution ($\Delta x$),
b) application d'une fonction d'apprentissage reposant sur au moins un réseau (56) neuronal d'apprentissage à l'ensemble (23) de données d'image RM comme donnée d'entrée, dans lequel la fonction d'apprentissage crée comme donnée de sortie une image (40) de sortie ayant une résolution ($\Delta w$) plus grande que celle de l'ensemble de données d'image RM,
c) segmentation de l'image de sortie de la fonction de l'apprentissage en des régions représentant de l'air (61) et des régions représentant du tissu (62, 63) biologique et affectation d'une valeur de susceptibilité déterminée à l'avance à chaque région segmentée, dans lequel on effectue ce stade c) en utilisant un troisième réseau (50) neuronal d'apprentissage, le troisième réseau neuronal recevant l'image de sortie comme donnée d'entrée et créant une répartition (33) de susceptibilité comme donnée de sortie, la répartition de susceptibilité comprenant au moins des valeurs pour de l'air, du tissu et éventuellement du poumon,
d) obtention d'une répartition (40) finale de susceptibilité, qui repose sur la répartition de susceptibilité du stade c).

**3.** Procédé mis en oeuvre par ordinateur pour déterminer la répartition (40) de susceptibilité d'un sujet en examen, le procédé comprenant les stades :

a) réception d'un ensemble (23) de données d'image RM acquis pendant une session d'examen d'une région (66) d'enregistrement recouvrant une partie du corps du sujet en examen et ayant une première résolution ($\Delta x$),
b) segmentation de l'ensemble de données d'image RM en des régions représentant de l'air (61) et des régions représentant du tissu (62, 63) biologique et affectation d'une valeur de susceptibilité déterminée à l'avance à chaque région segmentée, dans lequel on effectue ce stade b) en utilisant un troisième réseau (50) neuronal d'apprentissage, le troisième réseau neuronal recevant un ensemble (23) de données d'image RM comme donnée d'entrée et créant une répartition (33) de susceptibilité comme donnée de sortie, la répartition de susceptibilité comprenant au moins des valeurs pour de l'air, du tissu et éventuellement du poumon,
c) application d'une fonction d'apprentissage sur la base d'au moins un réseau (56) neuronal d'apprentissage à la répartition (33) de susceptibilité comme donnée d'entrée, dans lequel la fonction d'apprentissage crée comme donnée de sortie une image (40) de sortie ayant une résolution ($\Delta w$) plus grande que celle de l'ensemble de données d'image RM ou de l'ensemble de données d'image RM segmenté et/ou recouvrant une région (68) de sortie, qui est plus grande que la région (66) d'enregistrement de l'ensemble de données (23) d'image RM,
d) obtention d'une répartition (40) finale de susceptibilité, qui repose sur l'image de sortie,
dans lequel la fonction d'apprentissage comprend un deuxième réseau (52) neuronal recevant comme donnée d'entrée un ensemble (33, 37) de données d'image recouvrant la région (66) d'enregistrement et créant comme donnée de sortie, un ensemble (35, 39) de données d'image recouvrant une région (68) de sortie, qui est plus grande que la région d'enregistrement de sa donnée d'entrée,
dans lequel le procédé comprend les stades de

- identification de régions de repérage sur l'ensemble (23) de données d'image RM ou sur l'ensemble (33) de données d'image RM segmenté et création d'un ensemble de données d'image comprenant les régions de repérage,
- utilisation de l'ensemble de données d'image créé dans le stade a) comme donnée d'entrée dans le deuxième réseau (52) neuronal, dans lequel le deuxième réseau neuronal crée comme donnée de sortie un ensemble de données d'image de sortie recouvrant une région de sortie, qui est plus grande que la région d'enregistrement de sa donnée d'entrée,

dans lequel le deuxième réseau (52) neuronal a subi un apprentissage sur des paires d'atlas (24, 26) de référence du corps comme donnée d'apprentissage de sortie et des ensembles de données d'image comprenant des régions de repérage identifiées sur les atlas de référence du corps correspondant comme donnée d'apprentissage d'entrée,
dans lequel l'ensemble de données d'image de sortie comprend des régions de repérage, et dans lequel le procédé comprend les autres stades suivants :

- se procurer un atlas (24, 26) de référence du corps ayant une région (68) d'enregistrement plus grande que celle de la donnée (23) d'entrée RM,
- déterminer la position des régions de repérage dans l'ensemble de données d'image de sortie dans l'atlas de référence du corps et utiliser la donnée d'image de l'atlas (24, 26) de référence du corps pour remplir, de contenu (36) d'image, l'extérieur de la région (66) d'enregistrement dans l'image de sortie.

**4.** Procédé mis en oeuvre par ordinateur pour déterminer la répartition (40) de susceptibilité d'un sujet en examen, le procédé comprenant les stades :

a) réception d'un ensemble (23) de données d'image RM acquis pendant une session d'examen d'une région (66) d'enregistrement recouvrant une partie du corps du sujet en examen et ayant une première résolution ($\Delta x$),
b) application d'une fonction d'apprentissage sur la base d'au moins un réseau (56) neuronal d'apprentissage à l'ensemble (23) de données d'image RM comme donnée d'entrée, dans lequel la fonction d'apprentissage crée comme donnée de sortie une image (40) de sortie ayant une résolution ($\Delta w$) plus grande que celle de l'ensemble de données d'image RM et/ou recouvrant une région (68) de sortie, qui est plus grande que la région (66) d'enregistrement de l'ensemble (23) de données d'image RM,
c) segmentation de l'image de sortie de la fonction d'apprentissage en des régions représentant de l'air (61) et des régions représentant du tissu (62, 63) biologique et affectation d'une valeur de susceptibilité déterminée à l'avance à chaque région segmentée, dans lequel on effectue ce stade c) en utilisant un troisième réseau (50) neuronal et d'apprentissage, le troisième réseau neuronal recevant l'image de sortie comme donnée d'entrée et créant une répartition (33) de susceptibilité comme donnée de sortie, la répartition de susceptibilité comprenant au moins des valeurs pour de l'air, du tissu et éventuellement du poumon,
d) obtention d'une répartition (40) finale de susceptibilité, qui repose sur la répartition de susceptibilité du stade c), dans lequel la fonction d'apprentissage comprend un deuxième réseau (52) neuronal recevant comme donnée d'entrée un ensemble (33, 37) de données d'image recouvrant la région (66) d'enregistrement et créant comme donnée de sortie, un ensemble (35, 39) de données d'image recouvrant une région (68) de sortie, qui est plus grande que la région d'enregistrement de sa donnée d'entrée,
dans lequel, le procédé comprend les stades de

- identification de régions de repérage sur l'ensemble (23) de données d'image RM ou sur l'ensemble (33) de données d'image RM segmenté et création d'un ensemble de données d'image comprenant les régions de repérage,
- utilisation de l'ensemble de données d'image créé dans le stade a) comme donnée d'entrée dans le deuxième réseau (52) neuronal, dans lequel le deuxième réseau neuronal crée comme donnée de sortie un ensemble de données d'image de sortie recouvrant une région de sortie, qui est plus grande que la région d'enregistrement de sa donnée d'entrée,

dans lequel le deuxième réseau (52) neuronal a subi un apprentissage sur des paires d'atlas (24, 26) de référence du corps comme donnée d'apprentissage de sortie et des ensembles de données d'image comprenant des régions de repérage identifiées sur les atlas de référence du corps correspondant comme donnée d'apprentissage d'entrée,
dans lequel l'ensemble de données d'image de sortie comprend des régions de repérage, et dans lequel le procédé comprend les autres stades suivants :

• se procurer un atlas (24, 26) de référence du corps ayant une région (68) d'enregistrement plus grande que celle de la donnée (23) d'entrée RM,
• déterminer la position des régions de repérage dans l'ensemble de données d'image de sortie dans l'atlas de référence du corps et utiliser la donnée d'image de l'atlas (24, 26) de référence du corps pour remplir, de contenu (36) d'image, l'extérieur de la région (66) d'enregistrement dans l'image de sortie.

**5.** Procédé suivant l'une des revendications précédentes, dans lequel le troisième réseau neuronal a au moins quatre couches cachées.

**6.** Procédé suivant l'une des revendications 3 à 5, dans lequel le deuxième réseau neuronal a au moins quatre couches cachées et/ou le deuxième réseau neuronal reçoit comme autre donnée d'entrée des caractéristiques du sujet en examen ou de la session en examen, en particulier une ou plusieurs du groupe comprenant :

• posture du sujet en examen,
• sexe, âge, taille et/ou poids du sujet en examen,
• le type de la séquence RM utilisée dans l'acquisition de l'ensemble (23) de données d'image RM,
• la partie du corps représentée par l'ensemble de données d'image RM,
• la position de la table (9) RM,
• la dimension de la région (66) d'enregistrement,
• donnée de caméra du sujet en examen, en particulier d'une caméra en 3D,
• donnée d'un matelas sensible à la pression sous le sujet en examen.

**7.** Procédé suivant l'une des revendications précédentes, dans lequel la fonction d'apprentissage comprend un premier réseau (54) neuronal d'apprentissage recevant comme donnée d'entrée l'ensemble (23) de données d'image RM ou la répartition (33) de susceptibilité et créant comme donnée de sortie un ensemble (37) de données d'image RM ou une autre répartition (40) de susceptibilité ayant le même contenu et une résolution plus grande que celle de la donnée d'entrée.

**8.** Procédé suivant la revendication 7, dans lequel le premier réseau neuronal a au moins 4 couches cachées et/ou le premier réseau neuronal reçoit comme autre donnée d'entrée des caractéristiques du sujet en examen ou de la session d'examen, en particulier une ou plusieurs du groupe comprenant :

• posture du sujet en examen,
• sexe, âge, taille et/ou poids du sujet en examen,
• le type de la séquence RM utilisée dans l'acquisition de l'ensemble (23) de données d'image RM,
• la partie du corps représentée par l'ensemble de données d'image RM,
• la position de la table (9) RM,
• la dimension de la région (66) d'enregistrement,
• donnée de caméra du sujet en examen, en particulier d'une caméra en 3D,
• donnée d'un matelas sensible à la pression sous le sujet en examen.

**9.** Procédé suivant l'une des revendications 3 à 6 et l'une des revendications 7 à 8, dans lequel la fonction d'apprentissage comprend un seul réseau (56) neuronal d'apprentissage, qui est en particulier une combinaison des premier et deuxième et éventuellement troisième réseaux neuronaux.

**10.** Procédé suivant la revendication 9, dans lequel le seul réseau neuronal a au moins 4 couches cachées et/ou le seul réseau neuronal reçoit comme autre donnée d'entrée les caractéristiques du sujet en examen ou de la session d'examen, en particulier une ou plusieurs du groupe comprenant :

• posture du sujet en examen,
• sexe, âge, taille et/ou poids du sujet en examen,
• le type de la séquence RM utilisée dans l'acquisition de l'ensemble (23) de données d'image RM,
• la partie du corps représentée par l'ensemble de données d'image RM,
• la position de la table (9) RM,
• la dimension de la région (66) d'enregistrement,
• donnée de caméra du sujet en examen, en particulier d'une caméra en 3D,
• donnée d'un matelas sensible à la pression sous le sujet en examen.

**11.** Procédé suivant l'une des revendications 5, 6, 8 ou 10, dans lequel le nombre ($2*N_{ges}$) des neurones (21) artificiels d'au moins une couche (16, 17, 18, 19) cachée est au moins deux fois aussi grand que le nombre ($N_{ges}$) des neurones (21) artificiels d'une couche (15) d'entrée.

**12.** Programme d'ordinateur comprenant des instructions, qui, lorsque le programme est exécuté par un ordinateur (12), font que l'ordinateur effectue le procédé suivant l'une des revendications 1 à 11.

**13.** Installation (1) de résonance magnétique comprenant :

- un scanner (2) d'acquisition de données RM comprenant un émetteur (3) en radiofréquence et un récepteur (4) RF et un agencement (5, 6, 7, 8) de bobine de gradient,
- une mémoire dans laquelle des ensembles (23) de données d'image RM, éventuellement des répartitions de susceptibilité de référence, et une fonction (14) d'apprentissage sont mises en mémoire,
- un ordinateur (12) ayant accès à ladite mémoire (13) et étant configuré pour lire lesdits ensembles (23) de données d'image, éventuellement lesdites répartitions (24, 26) de susceptibilité de référence, et ladite fonction (14) d'apprentissage dans ladite mémoire (13) et,
- ledit ordinateur (12) étant configuré pour effectuer le procédé suivant l'une des revendications 1 à 11.

FIG 1

1
10
3
4
7
6
12
9
13
8
11
5
2

FIG 2
21
22
1
...
N_ges
2
3
4
14
21
23
N_ges
15
2*N_ges 16
2*N_ges 17
2*N_ges 18
2*N_ges 19
20

FIG 3

24
25
$\chi_{air}$
$\chi_{water}$
$\chi_{lung}$
$\chi_{water}$
$\chi_{water}$

FIG 4

26
$\chi_{air}$
$\chi_{water}$
$\chi_{lung}$
$\chi_{water}$
$\chi_{water}$

FIG 5
66
23
50
61
62
63
33
52
24 ,26
36
z
66
35
36
54
40

FIG 6
23
54
37
52
28
40
36
61
66
Z
62
39
50
36
61
63

FIG 7

66
23
28
56
36
66
68
36
40

FIG 8

S1
S2
S3.1
S3.2
S3.3
S3.4
S4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019157174 A1
- US 2004032261 A1


### Non-patent literature cited in the description


- **RARES SALOMIR et al.** A Fast Calculation Method for Magnetic Field Inhomogeneity due to an Arbitrary Distribution of Bulk Susceptibility. *Concepts in Magnetic Resonance,* 2003, vol. 19B (1), 26-34
- **LUNDERVOLD LEXANDER SELVIKVÄG et al.** An overview of deep learning in medical imaging focusing on MRI. *ZEITSCHRIFT FUER MEDIZINISCHE PHYSIK,* 13 December 2018, vol. 29 (2), 102-127
- **BASTY NICOLAS et al.** Super Resolution of Cardiac Cine MRI Sequences Using Deep Learning. *12TH EUROPEAN CONFERENCE ON COMPUTER VISION, ECCV 2012; [LECTURE NOTES IN COMPUTER SCIENCE,* 12 September 2018, 23-31